# EUROPEAN PATENT APPLICATION

(11) **EP 4 475 182 A1**
(43) Date of publication of application: **11.12.2024**
(21) Application number: 24177614.5
(22) Date of filing: 23.05.2024
(51) Int. Cl.: H01L 23/495, H01L 23/31, H01L 21/48, H01L 21/683

(54) **PACKAGED SEMICONDUCTOR DEVICES AND METHODS OF MAKING THE SAME**

(30) Priority: 07.06.2023 CN 202310670954
(71) Applicant: NXP USA, Inc., Austin TX 78735 (US)
(72) Inventor: Ge, You, 5656AG Eindhoven (NL); Wang, Zhijie, 5656AG Eindhoven (NL); Lee, Yit Meng, 5656AG Eindhoven (NL)
(74) Representative: Hardingham, Christopher Mark

(57) **Abstract**

Disclosed is a packaged semiconductor device having first and second major surfaces and comprising, a semiconductor die; conductive epoxy in contact with a surface of the semiconductor die, and exposed in a central region of the first major surface; a plurality of studs around a peripheral region of the first major surface; wire bonds between the semiconductor die and a surface of the studs which is remote from the first major surface, the wire bonds providing electrical connections between the semiconductor die and the plurality of studs; and encapsulant defining the second major surface and sidewalls of the packaged semiconductor device, wherein the first major surface is defined by the conductive epoxy, the encapsulant, and the studs.

## Description

### Field

The present disclosure relates to packaged semiconductors and to methods of making the same. In particular it relates to so called lead-less packages such as ball grid array (BGA) packages, so called quad flat no lead (QFN) packages and similar packages.

### Background

Excluding the cost of the semiconductor die itself, one of the most expensive components in a packaged semiconductor device is the lead frame which conventionally is electrically connected to the semiconductor die and provides means for electrical connection to the package. Furthermore, conventional lead frames may involve complex geometrical patterns, and, or in the alternative, may involve complex and delicate processing.

### Summary

According to a first aspect of the present disclosure, there is provided a packaged semiconductor device having first and second major surfaces and comprising, a semiconductor die; conductive epoxy in contact with a surface of the semiconductor die, and exposed in a central region of the first major surface; a plurality of studs around a peripheral region of the first major surface; wire bonds between the semiconductor die and a surface of the studs which is remote from the first major surface, the wire bonds providing electrical connections between the semiconductor die and the plurality of studs; and encapsulant defining the second major surface and sidewalls of the packaged semiconductor device, wherein the first major surface is defined by the conductive epoxy, the encapsulant, and the studs. Such a device may have been assembled without the requirement for any lead frame. In turn, this may result in a relatively low bill of materials for the semiconductor assembly.

In one or more embodiments, the semiconductor device further comprises solder balls affixed to the studs at the first major surface. In one or more such embodiments, the semiconductor device package is a ball grid array (BGA) package.

In one or more embodiments, the studs are wire studs. In one or more such embodiments, the wire studs are comprised of copper wire. In one or more embodiments, the studs are wire-bond bumps.

According to a second aspect of the present disclosure, there is provided a method of manufacturing a packaged semiconductor die, the method comprising: providing a metal foil on a carrier substrate; affixing a semiconductor die on the metal foil by a conductive epoxy; bonding a plurality of studs onto the metal foil around the semiconductor die; wire bonding the semiconductor die to the plurality of studs; encapsulating the semiconductor die, wire bonds, and studs with an encapsulant; removing the carrier substrate; removing the metal foil; and singulating the packaged semiconductor die. Providing a metal foil on a carrier substrate, both of which are subsequently removed, allows the formation of a metal stud by bump bonding, onto a conventional - that is to say metal - substrate. The stud may replace the functionality of conventional fingers of a lead frame.

In one or more embodiments, the metal foil is a one of aluminium and copper. These two metals are particularly convenient for the subsequent bump bonding of the stud, since bump bonding onto either copper or aluminium are both well understood technologies. However the disclosure is not limited to any particular metal, and a different metal or metal alloy may be used instead of aluminium or copper in circumstances where this is convenient, either because of cost purposes or for technological reasons such as, but not limited to, oxidation or ease of subsequent removal.

In one or more embodiments, the stud is copper. Bump bonding using copper as the wire to form the stud may be particularly convenient, since the chemistry of copper in the semiconductor industry is well understood, and copper is a relatively inexpensive material. However the disclosure is not limited thereto, and other metals or alloys may be used instead of copper, such as gold, or silver.

In one or more embodiments, the studs have a diameter in a range of 100 µm to 200 µm. The skilled person will appreciate that the studs are preferably of at least the same diameter or a greater diameter than the wire used for subsequent wire bonding between the studs and the semiconductor die. The diameter of the wire used for the wire bonding may be chosen to be compatible with the any particular application. Wire bonding using wire of a range between 25 µm and 100µm may be particularly convenient, and thus a stud diameter equal to or greater than 100 µm may be convenient. However, the disclosure is not limited thereto, and the size of the stud may depend on the application of the packaged semiconductor device.

In one or more embodiments, the method further comprises, prior to singulating the packaged semiconductor die, the step of attaching solder balls to the studs. The studs may thus act as a suitable anchor points for solder balls which form the ball grid array of an eventual device. It will be appreciated, that it may be desirable to have a larger number of solder balls than the number of separate electrical connections required to the semiconductor die. In such, or other, circumstances, some of the studs may be left unconnected to the semiconductor die. That is to say there may be studs which are not wire bonded to the semiconductor die but are used as anchor points for solder balls. In other embodiments, all of the studs are wire bonded to the semiconductor die.

In one or more embodiments, the metal foil is affixed to the carrier substrate by an adhesive. In other embodiments, the metal foil may be directly bonded to the carrier substrate.

In one or more embodiments, the metal foil comprises at least one fiducial mark for a locating the semiconductor die. The skilled person will appreciate that the metal foil may include a plurality of fiducial marks for locating a plurality of semiconductor die. Alternatively, or in addition, the metal foil may include other pluralities of fiducial marks for locating a second plurality of semiconductor die, for example but not limited to the situation where the semiconductor die of the second plurality have a different size, to those of the first plurality. The same metal foil may thus be used for different applications and in particular for the packaging of different types of semiconductor die. The skilled person will appreciate that this may result in a reduction in cost relative to conventional packaging processes in which the lead frames are generally specific to the dimensions of the semiconductor die.

These and other aspects of the invention will be apparent from, and elucidated with reference to, the embodiments described hereinafter.

### Brief description of Drawings

Embodiments will be described, by way of example only, with reference to the drawings, in which
FIG. 1 illustrates a plan view and a cross-section of an assembly of sacrificial metal foil mounted on a carrier substrate, which may be used in place of the lead frame;
FIG. 2 shows a plurality of part processed packaged semiconductor devices, according to embodiments, at a later stage of the process, in plan view and cross-section;
FIG. 3 shows a plurality of part processed packaged semiconductor devices, according to embodiments, at a still later stage of the process, in plan view and cross-section;
FIG. 4a shows, pictorially, a process for making studs or bumps, using a process known as a stud bump bonding;
FIG. 4b shows, schematically the resulting stud or bump. The stud comprises a flattened ball, which is integrally connected to a folded and partially flattened section of wire;
FIG. 5a shows a plurality of part processed packaged semiconductor devices, according to embodiments, at a yet later stage of the process, in cross section;
FIG. 5b shows the detail of a stud having a wire bonded thereto;
FIG.s 6, 7 and 8 shows a plurality of part processed packaged semiconductor devices, according to embodiments, at a yet later stage of the process, in cross section;
FIG. 9 shows a configuration, in which the foil is removed over only part of the devices;
FIG. 10 shows a plurality of part processed packaged semiconductor devices, according to one or more embodiments, at a still later stage of the process, in cross section.
FIG. 11 shows, schematically singulation of the devices into individual packaged semiconductor devices;
FIG. 12 shows, schematically a rear cross-section of a packaged semiconductor device according to one or more embodiments;
FIG. 13 shows a cross-section through a packaged semiconductor device, according to one or more embodiments;
FIG. 14 shows the device according to one or more embodiments mounted onto a circuit board such as a printed circuit board;
FIG. 15 shows a cross-section through a packaged semiconductor device, which in this case is a BGA device, according to one or more other embodiments;
FIG. 16 shows the BGA device according to one or more embodiments mounted onto a circuit board such as a printed circuit board; and
FIG. 17 shows a flow diagram according to one or more embodiments of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

Viewed from one perspective, embodiments of the present disclosure may obviate the need for a geometrically complex lead frame to be used, and separated into two parts, during the assembly of a lead-less packaged semiconductor device. In conventional assembly processes of a packaged semiconductor device, one or more semiconductor die are typically mounted onto a central part of a lead frame, which central part may be referred to as a die plate. Electrical contact pads on the semiconductor die are then wire-bonded to other parts of the lead frame, typically referred to as fingers, typically while the fingers are still attached to the die plate. The fingers are then electrically isolated from the die plate, during a multistage encapsulation process, at the end of which at least part of the fingers are exposed on a first major surface, which may be a bottom surface, of the packaged device. In the case of a QFN package, the isolated fingers may extend to the edge of the device. Conversely, in the case of a BGA package, the exposed part of the fingers may be distributed across the bottom of the device, and may subsequently have solder balls attached thereto to form the ball grid array.

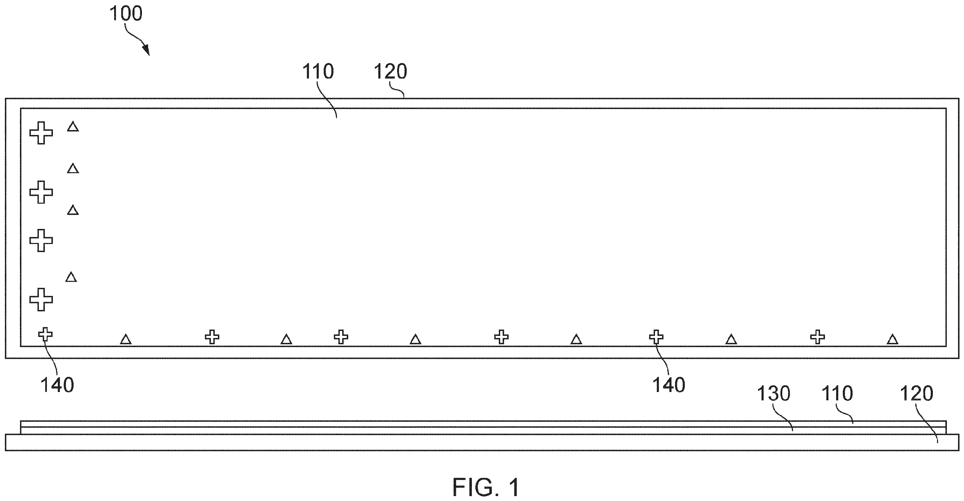

FIG. 1 illustrates a plan view and a cross-section of an assembly 100 of sacrificial metal foil 110 mounted on a carrier substrate 120, which may be used in place of the lead frame. The metal foil may in particular be an aluminium foil or a copper foil although other metals may alternatively be used. The thickness of the foil may be in a range between 20 µm and 200 µm, a preferred range for the foil thickness may be 25 µm to 50 µm. The foil is affixed to a carrier substrate 120 by means of an adhesive layer 130. The carrier substrate may be made of any suitable for material. Such materials may include a plastic material or metal material such as stainless steel. The foil may include one or more reference marks on fiducial marks 140 therein such as the cut-outs shown. The fiducial marks 140 may be used for location of one, or a plurality, of semiconductor die. The assembly may be provided with a plurality of different types of fiducial marks 140, which may be used for different die size or different package size. A single assembly may thus be compatible with a range of different types and/or sizes of semiconductor package, which may simplify the bill of materials for a range of products, in comparison with conventional packaging processes in which the lead frame is typically dedicated to a specific package size, QFN contact layout, or BGA design.

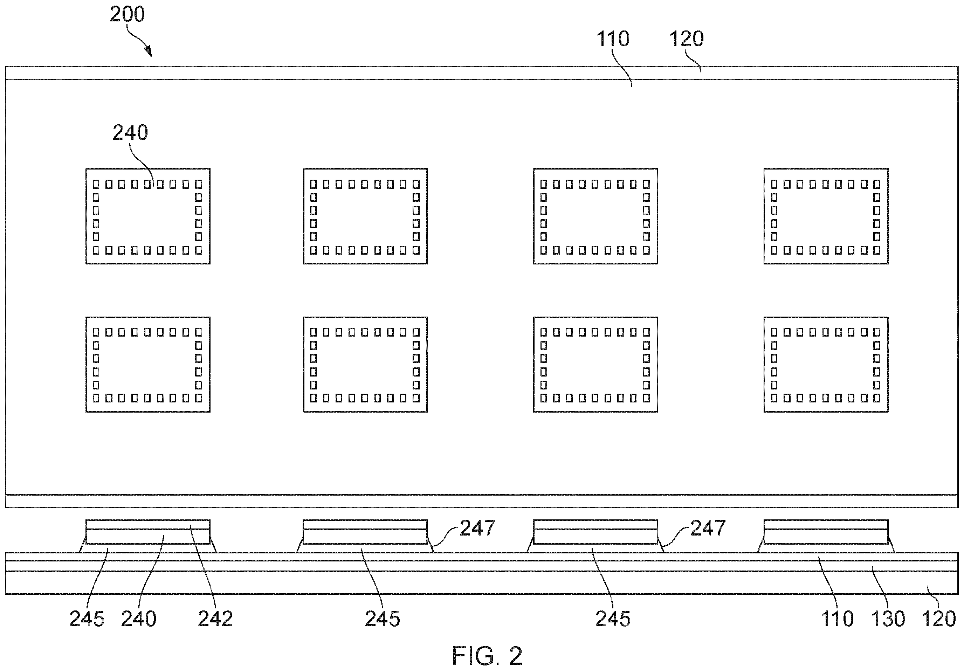

FIG. 2 shows a plurality 200 of part processed packaged semiconductor devices, according to embodiments, at a later stage of the process, in plan view and cross-section. The FIG. shows an assembly of the carrier substrate at 120 and metal foil 110, with a plurality of semiconductor die 240 mounted thereon, the semiconductor die have an active circuits in an upper region 242 thereof. The semiconductor die 240 are affixed to the metal foil 110 by means of a conductive epoxy 245. The conductive epoxy typically covers the whole of the surface of each die, and as shown may extend around the edge of the die, by spacers 247.

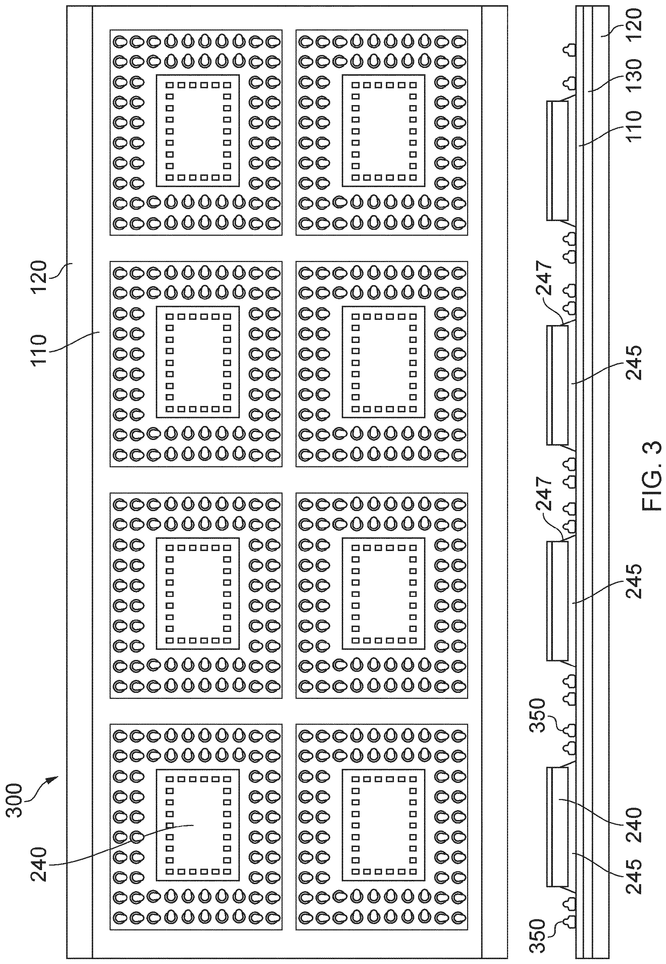

FIG. 3 shows a plurality 300 of part processed packaged semiconductor devices, according to embodiments, at a still later stage of the process, in plan view and cross-section. The FIG. shows the assembly of the metal foil 110 mounted on carrier substrate 120 by adhesive 130, having a plurality of semiconductor die 240 affixed thereto by means of conductive epoxy 245. Around each of the die are a plurality of metal studs or bumps 350. The bumps may be conveniently formed of Cu, although the disclosure is not limited thereto. As shown in FIG. 3, the studs or bumps 350 may be arranged around all four sides of each of the semiconductors die. In other embodiments they may be arranged around fewer side such as only two sides. Furthermore, as shown studs or bumps 350 may be arranged in two or more parallel lines, or there may be only one row of studs or bumps 350.

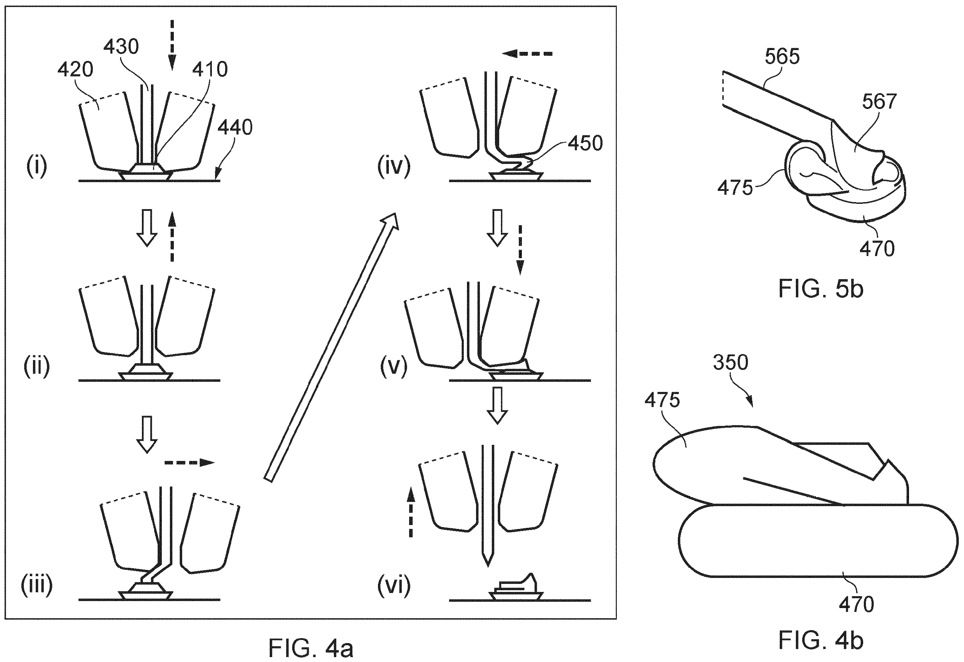

FIG. 4a shows, pictorially, a process for making studs or bumps 350, using a process known as a stud bump bonding. Stud bump bonding is a modified wire bonding process, in which a bond is formed between a balled end of a wire and a substrate, and the wire is then broken above the bond leaving just a stud, or bump. As shown at (i), wire 430 is extruded through a capillary 420, and a ball is formed at the end of the wire, typically by a high voltage spark which melts the tail of the wire and relying on surface tension to create a ball having a larger diameter than the wire itself. A tool, which is typically referred to as a bonding head holding the capillary is then lowered to press the ball end of the wire onto the surface 440. In this case the surface is the surface of the metal foil. The ball is thereby squashed to result in a bump bond 410. The tool and capillary are raised as shown at (ii). Next, the tool and capillary are moved laterally, first in one direction as shown at (iii), and then in an opposite direction, as shown at (iv), resulting in a fold 450 in the wire immediately above the bump. The tool is then lowered, as shown at (v), which further stresses and deforms the wire next to the fold and generally breaks the wire. Finally, the tool and capillary are raised, which breaks the wire in case it has not already broken at (v). FIG. 4b shows, schematically the resulting stud or bump 350. The stud comprises a flattened ball 470, which is integrally connected to a folded and partially flattened section of wire 475. The partial flattening resulting from step (v) above results in at least part of the top surface of the stud or bump 350 being flat and level (at least relative to the original wire shape which is typically circular). This flat top surface of the stud or bump is suitable for a further wire bonding operation, as will be discussed in more detail hereinbelow.

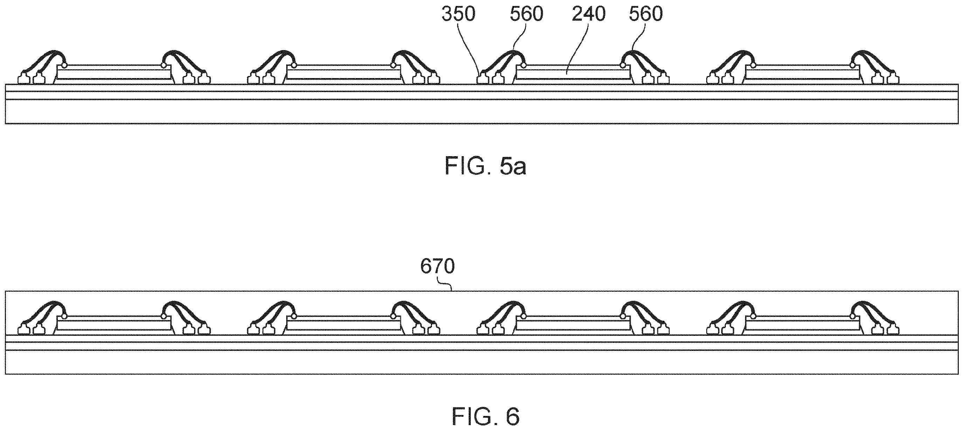

FIG. 5a shows a plurality of part processed packaged semiconductor devices, according to embodiments, at a yet later stage of the process, in cross section. Wire bonds 560 are made between individual studs or bumps 350 and the semiconductor die 240. The wire bonds are made between the studs which are made of typically copper, and the contact pads on the top surface of semiconductor die. The contact pads on a top surface of the die are typically of copper or aluminium. Commonly used is an aluminium material, doped or alloyed with a small amount of copper, such as < 2%. The wire bonds 560 are conventional wire bonds such as will be familiar to the skilled person in the field, except that one end of the wire bond is made directly onto the stud or bump 350.

FIG. 5b shows the details of a stud or bump 350 having a wire 565 bonded thereto. The wire bonded to the stud may form part of a wire bond 560. The flattened ball 470 which forms the lower part of the stud is visible as is a partially flattened section of wire 475. The stud is formed of a first material which is typically copper as mentioned above. The wire 565 is bonded to the stud by means of the bond shown at bond site 567. At the bond site 567, the wire is deformed by the bonding tool as will be familiar to the skilled person. The bonding may be by known bonding technique, such as, without limitation, thermosonic bonding, thermo-compression bonding, or ultrasonic bonding

FIG. 6 shows a plurality of part processed packaged semiconductor devices, according to embodiments, at a yet later stage of the process, in cross section. Encapsulant 670 has been provided over and around the semiconductor die 240, studs or bumps 350 and wire bonds 560 to encapsulate the devices. As shown, a plurality of semiconductor die, which will eventually form a plurality of packaged semiconductor devices, may be encapsulated together. It will be appreciated that during this encapsulation, the die is still mounted on the assembly of the carrier substrate and metal foil.

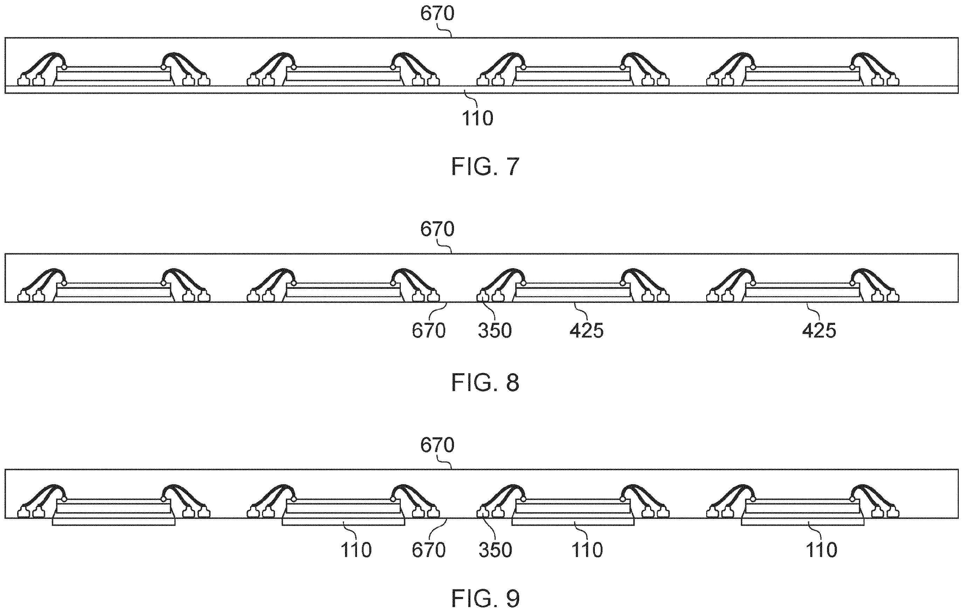

FIG. 7 shows a plurality of part processed packaged semiconductor devices, according to embodiments, at a yet later stage of the process, in cross section. The carrier has been removed from the part processed devices. Any one of a variety of means may be used to remove the carrier. For example according to some embodiments the carrier may be of stainless steel. Foil may be attached to the adhesive tape 130, and then both together held on to the carrier by vacuum during each process step. After the moulding process, the carrier vacuum may be switched off or stopped, or a vacuum seal otherwise broken, and the foil and adhesive tape 130 then may easily separate from the carrier. Next the adhesive tape 130 may be split or removed, generally without difficulty, since the whole strip now is supported by the moulding compound. Finally, the foil may be removed, for instance by mechanical polishing or chemo mechanical polishing (CMP). Removal of the carrier substrate 120 and adhesive 130 exposes the metal foil 110 on the backside of the devices.

FIG. 8 shows a plurality of part processed packaged semiconductor devices, according to embodiments, at a still later stage of the process, in cross section, in particular after the metal foil has been removed. The metal foil may be removed by either etching or a polishing or grinding process. As shown in FIG. 8, the entirety of the metal foil may be removed, thereby exposing the studs or bumps 350, part of the encapsulant, and the conductive epoxy. In other embodiments, the metal foil may be only partially removed. The skilled person will appreciate that such embodiments may not be compatible with grinding or other CMP processes and so typically will rely on patterning the backside of the devices and etching through the openings in the pattern. Such as configuration, in which the foil is removed over only part of the devices, is shown in FIG. 9.

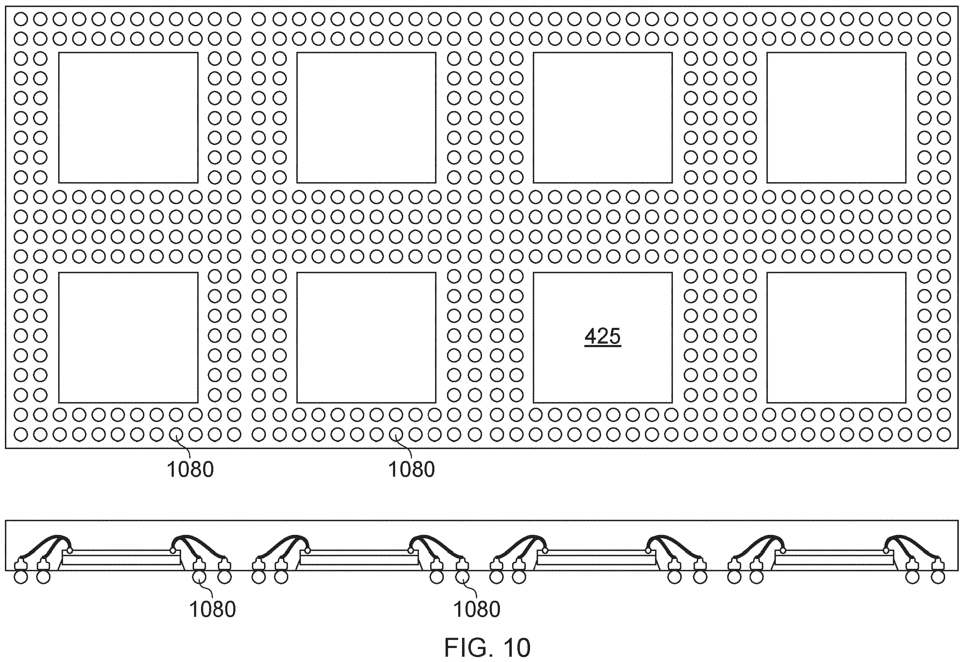

Figure 10 shows a plurality of part processed packaged semiconductor devices, according to one or more embodiments, at a still later stage of the process, in cross section. In particular, conductive balls, which are typically solder balls, are provided on the exposed bottom surface of the studs or bumps 350. The balls provide the balls of the eventual BGA devices. It will be appreciated that in some embodiments, such as those for which the eventual device is a QFN package, the step of providing balls may be omitted. The skilled person will be familiar with the details of processes by which the solder walls may be affixed to the studs or bumps 350.

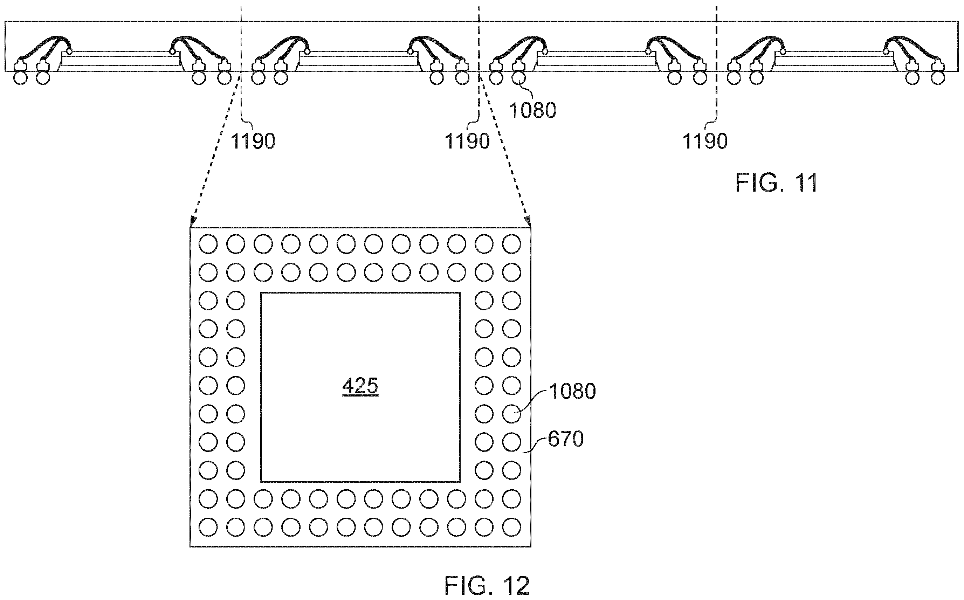

Fig. 11 shows, schematically singulation of the devices into individual packaged semiconductor devices. This is carried out using conventional techniques such as use saw cuts, shown schematically at 1190, within saw lanes between the devices.

FIG. 12 shows, schematically, a rear plan view and cross-section of a packaged semiconductor device according to one or more embodiments. The FIG. shows the plurality of solder balls 1080, in this case arranged around all four sides of the semiconductor device die and again in this case arranged in two parallel lines. In the embodiment shown, the conductive epoxy 245 is exposed in a central region of the packaged device. Between the exposed conductive epoxy 245 and the solder balls affixed to the studs or bumps 350 is encapsulant 670, which also defines the sidewalls and the top surface of the device.

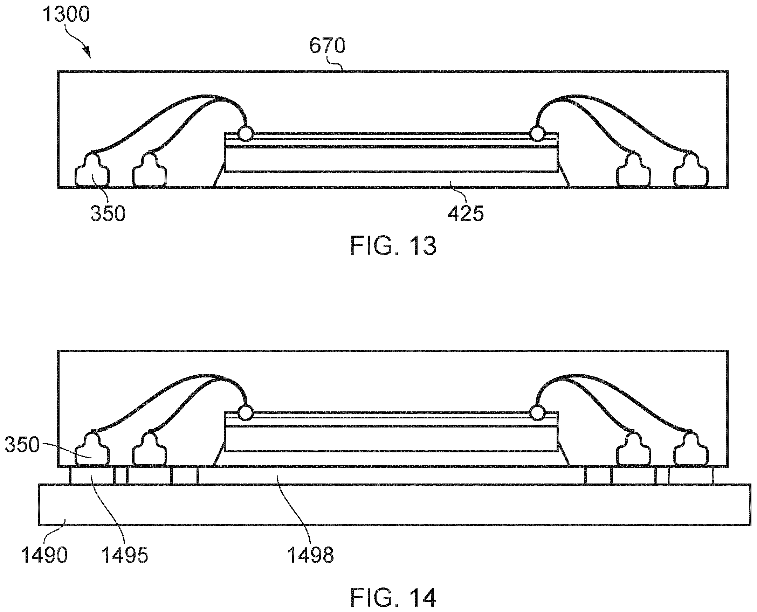

FIG. 13 shows a cross-section through a packaged semiconductor device 1300, according to one or more embodiments. As can be seen, the encapsulant 670 defines a top surface of the device as well as the sidewalls. The bottom surface of the device is defined by the encapsulant, the studs or bumps 350, and the conductive epoxy 425.

FIG. 14 shows the device 1300 according to one or more embodiments mounted onto a circuit board 1490 such as a printed circuit board. As can be seen the exposed surfaces of the studs upon 350, which may have plated (electroplated or electroless plated) surface thereon to assist in surface mount technology (SMT) plating process, are electrically connected to tracks 1495 on the circuit board, by means typically of solder paste1495. A further region of solder paste 1498 on the circuit board 1490 is bonds to the conductive adhesive.

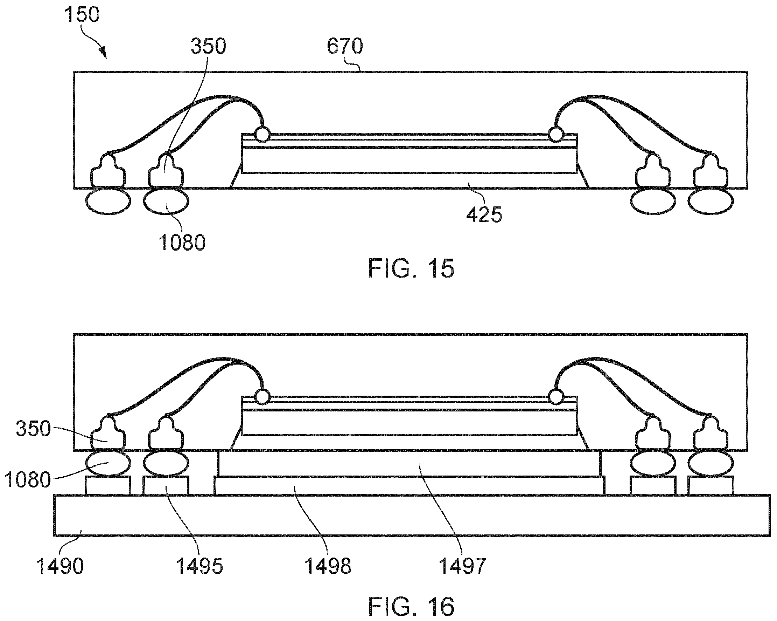

FIG. 15 shows a cross-section through a packaged semiconductor device 1500, which in this case is a BGA device, according to one or more other embodiments. As can be seen, the encapsulant 670 defines a top surface of the device as well as the sidewalls. A bottom surface of the device is defined by the encapsulant, the studs or bumps 350, and the epoxy 425. Solder balls 1080 are attached to the studs or bumps 350, and protrude below the bottom surface, thereby providing the balls of the BGA device.

FIG. 16 shows the BGA device 1500 according to one or more embodiments mounted onto a circuit board 1490 such as a printed circuit board. As can be seen the solder balls 1080 provide electrical contact between the BGA device 1500 and tracks 1495 on the circuit board 1490. A further track or sheet 1498 on the circuit board 1490 is connected to the conductive adhesive 425 by means of an additional solder sheet 1497.

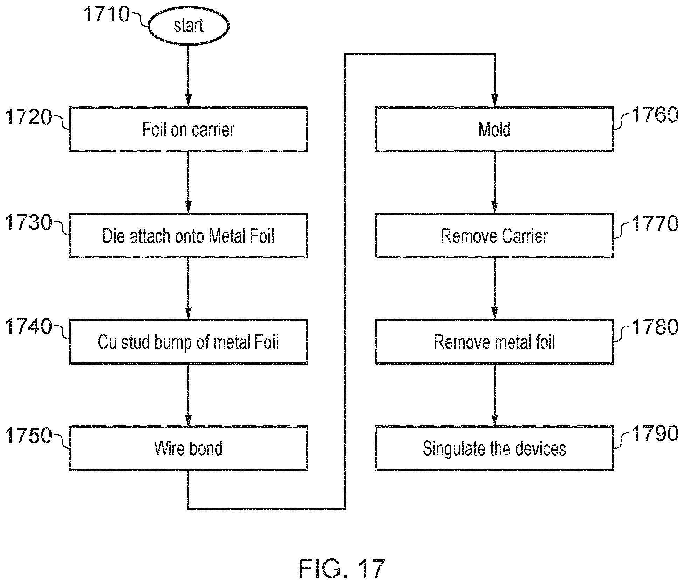

FIG. 17 shows a flow diagram according to one or more embodiments of the present disclosure. In particular, the flow diagram shows method of manufacturing a packaged semiconductor die, the method comprising prior processing, at 1710; providing a metal foil on a carrier substrate at 1720; affixing a semiconductor die on the metal foil by a conductive epoxy, at 1730; bonding a plurality of studs onto the metal foil around the semiconductor die, at 1740; wire bonding the semiconductor die to the plurality of studs, at 1750; encapsulating the semiconductor die, wire bonds, and studs with an encapsulant such as a moulding compound, at 1760; removing the carrier substrate 1770; removing the metal foil, at 1780; and singulating the packaged semiconductor die at 1790. Optionally, the method may include, at 1785, a ball attach process, to attach solder balls to the exposed surface of the studs or bumps.

From reading the present disclosure, other variations and modifications will be apparent to the skilled person. Such variations and modifications may involve equivalent and other features which are already known in the art of semiconductor device processing, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

It is noted that one or more embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

## Claims

1. A packaged semiconductor device having first and second major surfaces and comprising,
a semiconductor die;
conductive epoxy in contact with a surface of the semiconductor die, and exposed in a central region of the first major surface;
a plurality of studs around a peripheral region of the first major surface;
wire bonds between the semiconductor die and a surface of the studs which is remote from the first major surface, the wire bonds providing electrical connections between the semiconductor die and the plurality of studs; and
encapsulant defining the second major surface and sidewalls of the packaged semiconductor device,
wherein the first major surface is defined by the conductive epoxy, the encapsulant, and the studs.

2. The packaged semiconductor device as claimed in claim 1,
further comprising solder balls affixed to the studs at the first major surface.

3. The packaged semiconductor device as claimed in claim 2,
wherein the semiconductor device package is a ball grid array (BGA) package.

4. The packaged semiconductor device as claimed in any preceding claim,
wherein the studs are wire studs.

5. The packaged semiconductor device as claimed in claim 4,
wherein the wire studs are comprised of copper wire.

6. The packaged semiconductor device as claimed in any preceding claim,
wherein the studs are wire-bond bumps.

7. The packaged semiconductor device as claimed in claim 6, wire-bond bumps comprise a thermosonic bond-site.

8. A method of manufacturing a packaged semiconductor die, the method comprising:
providing a metal foil on a carrier substrate;
affixing a semiconductor die on the metal foil by a conductive epoxy;
bonding a plurality of studs onto the metal foil around the semiconductor die;
wire bonding the semiconductor die to the plurality of studs;
encapsulating the semiconductor die, wire bonds, and studs with an encapsulant;
removing the carrier substrate;
removing the metal foil; and
singulating the packaged semiconductor die.

9. The method of claim 8 wherein the metal foil is a one of aluminium and copper.

10. The method of any of claims 8 to 9, wherein the stud is copper.

11. The method of any of claims 8 to 10, wherein the studs have a diameter in a range of 100 µm to 200 µm.

12. The method of any of claims 8 to 11, wherein the step of bonding a plurality of studs onto the metal foil around the semiconductor die comprises thermosonic bonding.

13. The method of any of claims 8 to 12, further comprising, prior to singulating the packaged semiconductor die, the step of attaching solder balls to the studs.

14. The method of any of claims 8 to 13, wherein the metal foil is affixed to the carrier substrate by an adhesive.

15. The method of any of claims 8 to 14, wherein the metal foil comprises at least one fiducial mark for a locating the semiconductor die.
